# EUROPÄISCHE PATENTANMELDUNG

(11) **EP 1 598 937 A2**
(43) Veröffentlichungstag der Anmeldung: **23.11.2005**
(21) Anmeldenummer: 05010638.4
(22) Anmeldetag: 17.05.2005
(51) Int. Cl.: H03K 5/13, H03K 3/03

(54) **Schaltung mit wenigstens einer Verzögerungszelle**

(30) Priorität: 17.05.2004 DE 102004025386
(71) Anmelder: ATMEL Germany GmbH, 74072 Heilbronn (DE)
(72) Erfinder: Karthaus, Udo, Dr. Dipl.-Ing., 89079 Ulm (DE)

(57) **Zusammenfassung**

Vorgestellt wird eine Schaltung (10) mit wenigstens einer Verzögerungszelle (14), die eine Eingangssignaländerung verzögert in ein Ausgangssignal abbildet und die wenigstens zwei Paare (18, 20) von Invertern (22, 24, 26, 28) aufweist, wobei jeweils Ausgänge von Invertern (22, 24, 26, 28) eines Paares von Invertern (22, 24, 26, 28) miteinander verbunden sind, so dass die verbundenen Ausgänge eines ersten Paares von Invertern (22, 24, 26, 28) einen ersten Ausgang und die verbundenen Ausgänge eines zweiten Paares einen zweiten Ausgang der Verzögerungszelle (14) bilden. Die Schaltung (10) zeichnet sich dadurch aus, dass jeweils ein Eingang (38, 42, 58, 60) jedes Inverters (22, 24, 26, 28) getrennt von Eingängen anderer Inverter (22, 24, 26, 28) mit einem eigenen Eingang (62, 64, 66, 68) der Verzögerungszelle (14) verbunden ist.

## Beschreibung

Die Erfindung betrifft eine Schaltung mit wenigstens einer Verzögerungszelle, die eine Eingangssignaländerung verzögert in ein Ausgangssignal abbildet und die wenigstens zwei Paare von Invertern aufweist, wobei jeweils Ausgänge von Invertern eines Paares von Invertern miteinander verbunden sind, so dass die verbundenen Ausgänge eines ersten Paares von Invertern einen ersten Ausgang und die verbundenen Ausgänge eines zweiten Paares einen zweiten Ausgang der Verzögerungszelle bilden.

Verzögerungszellen dienen beispielsweise zur Erzeugung von elektrischen Schwingungen in einem spannungsgesteuerten oder stromgesteuerten Oszillator oder zur verzögerten Weitergabe einer Eingangssignaländerung in einem signalverarbeitenden Schaltkreis.

Eine Schaltung der eingangs genannten Art ist aus der US 5 300 898 bekannt. Diese Schrift beschreibt eine Variante eines nicht-symmetrischen Ringoszillators aus CMOS-Invertern. Der Ringoszillator weist eine ungerade Anzahl von Verzögerungszellen, insbesondere drei solcher Zellen, als Oszillatorzellen, auf. Die Zellen sind zu einem Ring verbunden, so dass das Signal einer beliebigen Zelle nach ungeradzahlig häufiger Invertierung jeweils wieder auf diese Zelle zurückgeführt wird und dort eine erneute Invertierung des Ausgangssignals dieser Zelle erzeugt. Als Folge stellt sich in dem Ring eine periodische Schwingung, also ein periodischer Wechsel des Ausgangssignalpegels jeder Zelle, ein. Verbindet man dagegen bei der Topologie der US 5,300,898 eine geradzahlige Anzahl von Zellen zu einem Ring, so führt die Invertierung eines Signals durch eine bestimmte nach einem Durchlaufen des Rings nicht zu einer erneuten Invertierung in der bestimmten Zelle. Es kommt daher bei der geradzahligen Struktur nicht zu einer periodischen Schwingung sondern zur Einstellung eines von zwei möglichen stabilen Zuständen.

Die Zellen weisen beim Gegenstand der US 5,300,898 differentielle Inverter auf, bei denen die Kopplung zweier Inverter durch gemeinsame Stromquellen realisiert wird. Dabei wird unter einem differentiellen Inverter eine Parallelschaltung von Einzelinvertern verstanden, die differentielle Eingangssignale erhält, zum Beispiel eine logische 1 für den einen Inverter und eine logische 0 für den anderen Inverter, oder umgekehrt. Der eine Inverter stellt einen ersten Eingang und Ausgang einer Oszillatorzelle dar und der parallel liegende andere Inverter stellt einen zweiten Eingang und Ausgang der Oszillatorzelle dar. Die Oszillatorzellen sind nach der US 5 300 898 in einer Ringkonfiguration verbunden, wobei der erste (respektive zweite) Eingang einer Oszillatorzelle jeweils an einem ersten (respektive zweiten) Ausgang einer vorhergehenden Oszillatorzelle liegt. Dadurch werden gewissermaßen zwei Ketten gebildet, wobei eine erste Kette dem Signalfluss über die ersten Eingänge entspricht und eine zweite Kette dem Signalfluss über die zweiten Eingänge und Ausgänge entspricht. Theoretisch treten damit bei fortlaufend synchron erfolgender Signalinvertierung in den beiden Ketten hinter jeder Oszillatorzelle komplementäre (z.B. 0, 1) Phasen des übertragenen Signals auf.

Durch die Stromquellen werden die Inverter langsamer als wenn sie an feste Versorgungsspannungswerte angeschlossen wären. Um noch ausreichend kurze Verzögerungszeiten zu erreichen, müssen als Stromquellen dienende Transistoren im Trioden-Bereich betrieben werden, in dem sie ein lineares Widerstands-Verhalten zeigen. Zur Erzielung hoher Frequenzen muss der Widerstand dieser Stromquellen sehr gering sein. Bei einem geringen Widerstand wird aber die Kopplung der parallel liegenden Inverter immer geringer. Daher besteht bei hohen Frequenzen grundsätzlich die Gefahr, dass die beiden Inverter-Ketten nicht synchron laufen.

Als weiteres Beispiel eines Oszillators mit symmetrischen Differenzstufen wird auf die US 2003034850 verwiesen, die eine Realisierung der Differenzstufen in BiCMOS-Technologie (BiCMOS = Verbindung von Bipolar- und CMOS-Technologie) zeigt. Eine solche Differenzstufe ist jedoch vermutlich langsamer als ein Inverter, weil die Gate-Ansteuerspannung kleiner ist. Außerdem nehmen die Verzögerungszellen solcher Ringoszillatoren permanent Strom auf. Die Stromaufnahme ist daher proportional zur Anzahl der Verzögerungszellen. Da der Spannungshub je nach Lastwiderstand und Strom klein ist und nicht in der Mitte der Versorgungsspannung liegt, sind die Signale im Ring nicht CMOSkompatibel. Man benötigt daher zur Auskopplung der Signale eine etwas kompliziertere Schaltung (meist Differenzverstärker), die ebenfalls permanent Strom aufnimmt.

Die WO 01/43274 A2 zeigt einen Oszillator, bei dem bistabile Verstärker als Verzögerungszellen zu einem Oszillator zusammengeschaltet sind, der eine Auskopplung verschiedener Signale mit zueinander komplementären Phasen erlaubt.

Neben solchen Ringoszillatoren aus symmetrischen Differenzstufen sind auch nichtsymmetrische (nicht-differentielle) Ringoszillatoren mit Verzögerungszellen aus CMOS-Invertem bekannt. Eine Variante einer solchen Struktur ist zum Beispiel aus der DE 197 28 248 bekannt. Diese Ringoszillatoren besitzen nur einen Ring und damit eine ungerade Anzahl von Phasen, weil eine gerade Anzahl eine ebensolche Anzahl von Verzögerungszellen erfordern würde. Bei einer geraden Anzahl würde der Oszillator aber dann in einem von zwei möglichen stabilen Zuständen fest hängen. Der Abstand zwischen zwei aus dem Ring auskoppelbaren Signalen mit gleicher Phasenlage (z.B. 0 oder 1) entspricht zwei Inverterlaufzeiten, wobei hier unter der Inverterlaufzeit die übliche Gatterlaufzeit verstanden wird. Der Mindestabstand zwischen den Phasen ist damit unerwünscht groß.

Vor diesem Hintergrund besteht die Aufgabe der Erfindung in der Angabe einer Schaltung mit wenigstens einer Verzögerungszelle, die sich durch Aneinanderreihung mehrerer solcher Zellen zu einem geschlossenen Ringoszillator mit sehr kurzen Verzögerungszeiten oder Phasendifferenzen des Signals an Ausgängen aufeinander folgender Verzögerungszellen erweitern lässt.

Diese Aufgabe wird bei einer Schaltung der eingangs genannten Art dadurch gelöst, dass jeweils ein Eingang jedes Inverters getrennt von Eingängen anderer Inverter mit einem eigenen Eingang der Verzögerungszelle verbunden ist.

Durch dieses Merkmal wird die Aufgabe der Erfindung vollkommen gelöst. Da die miteinander verbundenen Ausgänge der Inverter eines Paars erfindungsgemäß über zwei voneinander getrennte Eingänge steuerbar sind, ergeben sich zusätzliche Freiheitsgrade bei Schaltkreisentwürfen, die mehrere solcher Verzögerungszellen aufweisen. So können beispielsweise an verschiedenen Stellen eines Ringoszillators abgegriffene Signale über die getrennten Eingänge in das Paar von Invertern eingespeist werden. Durch zeitlich versetztes Ansteuern der Eingänge kann zum Beispiel die Phasendifferenz zwischen den Ausgängen von aufeinanderfolgenden Paaren von Invertern wesentlich verkürzt werden.

Im Rahmen von Ausgestaltungen der Erfindung ist bevorzugt, dass die Inverter als CMOS-Inverter realisiert sind.

Gegenüber anderen Invertern verringern CMOS-Inverter, also Inverter mit komplementären N-Kanal und P-Kanal-Feldeffektransistoren, die Stromaufnahme der Schaltung, da logische CMOS-Elemente wie Inverter nur beim Übergang zwischen beiden stabilen Zuständen Strom in nennenswerter Stärke verbrauchen und zwischen solchen Übergängen praktisch stromlos arbeiten.

Bevorzugt ist auch, dass wenigstens ein Ausgang der Verzögerungszelle an ein Verstärkerelement angeschlossen ist.

Da ein Verstärker in der Regel einen hohen Eingangswiderstand und einen geringen Ausgangswiderstand hat, besitzt diese Ausgestaltung den Vorteil einer verringerten Rückwirkung von am Ausgang angeschlossenen Schaltkreisen auf die Signalbildung in der Verzögerungszelle.

Eine weitere bevorzugte Ausgestaltung zeichnet sich durch einen weiteren CMOS-Inverter als Verstärkerelement aus.

Weitere CMOS-Inverter können einfach zusammen mit den übrigen CMOS-Invertern der Schaltung durch einen CMOS-Prozess erzeugt werden. Die Realisierung der für eine Signalauskopplung verwendeten Verstärkerelemente durch CMOS-Inverter senkt darüber hinaus den Stromverbrauch der Schaltung, da die CMOS-Inverter nur bei Schaltvorgängen nennenswerte Ströme aufnehmen. Dadurch steigt der Stromverbrauch der Schaltung in erster Näherung nicht an, wenn man die Zahl der Inverter und damit der Signalphasen erhöht.

Bevorzugt ist auch, dass die Schaltung eine durch zwei teilbare Zahl von Verzögerungszellen aufweist, die größer oder gleich vier ist, wobei Eingänge wenigstens einer n-ten Verzögerungszelle mit Ausgängen von wenigstens einer n - 1 modulo N -ten und einer n - 2 modulo N -ten Verzögerungszelle verbunden sind. wobei N die Zahl der Verzögerungszellen angibt.

Diese Ausgestaltung realisiert die weiter oben als Möglichkeiten angegebenen Vorteile einer Steuerung des Ausgangssignals der ersten Verzögerungszelle durch Signale von zwei weiteren Verzögerungszellen. Insbesondere lässt sich damit ein geringer Phasenunterschied zwischen Signalen erzielen, die an Ausgängen aufeinander folgender Verzögerungszellen abnehmbar sind.

Alternativ ist bevorzugt, dass die wenigstens vier Verzögerungszellen so miteinander verbunden sind, dass sich ein erster Signalpfad über eine erste Kette von Invertern und ein zweiter Signalpfad über eine zweite Kette von Invertern ergeben, wobei Signale in beiden Signalpfaden mit entgegengesetzter Phase synchron fortschreiten und wobei Eingänge von Invertern der ersten Kette, die zu einer n-ten Verzögerungszelle gehören, an Ausgänge von Invertern der ersten Kette, die zu einer n - 2k +/- 1 modulo N -ten Verzögerungszelle gehören und an Ausgänge von Invertern der zweiten Kette, die, die zu einer n - 2k modulo N -ten Verzögerungszelle gehören, angeschlossen sind, wobei k eine natürliche Zahl größer oder gleich 1 ist.

Auch durch diese Ausgestaltung wird der Ausgang einer Verzögerungszelle von zwei Eingängen zeitlich versetzt angesteuert, so dass sich als Folge eine verringerte Phasendifferenz zwischen hinter Invertern einer Kette auskoppelbaren Signalen ergibt. Während sich bei einfachen Ringoszillatoren eine bestimmte Phase. die am Ausgang eines bestimmten Inverters auftritt, erst am Ausgang des übernächsten Inverters, also zwei Inverterlaufzeiten später wiederholt, findet eine Wiederholung bei der Ausgestaltung mit k = 1 bereits nach 2/3 einer Inverterlaufzeit statt. Für Werte k > 1 wird der Abstand zwischen gleichen Phasen noch kleiner.

Ferner ist bevorzugt, dass wenigstens vier Verzögerungszellen der Schaltung zu einem Ringoszillator verbunden sind.

Es ist ein besonderer Vorteil der Erfindung, dass sich auch mit einer geradzahligen Zahl von Verzögerungszellen, die größer oder gleich vier ist, ein Ringoszillator realisieren lässt. Der Stand der Technik zeigt dagegen nur Ringoszillatoren mit einer ungeradzahligen Zahl von Verzögerungszellen. Da jede Verzögerungszelle mit den Merkmalen der Erfindung eine Auskopplung von zwei Signalen mit komplementären Phasen erlaubt, lassen sich mit der Erfindung Ringoszillatoren entwerfen, die praktisch jede geradzahlige Zahl von gegeneinander phasenverschobenen Signalen mit einer minimalen Zahl von Verzögerungszellen liefern. Der Stand der Technik, der für das Ausbilden einer Schwingung in dem Ringoszillator eine ungerade Anzahl von Verzögerungszellen benötigt, liefert dagegen nur 6, 10, 14, ..... Möglichkeiten der Signalauskopplung, wenn man zwei auskoppelbare Signale pro Verzögerungszelle voraussetzt.

Eine weitere bevorzugte Ausgestaltung zeichnet sich durch wenigstens eine steuerbare Quelle elektrischer Energie aus, die an Versorgungsanschlüsse wenigstens eines der Inverter angeschlossen ist.

Durch die Steuerbarkeit der elektrischen Energieversorgung kann die Verzögerungszeit eines einzelnen Inverters und damit die Frequenz der Schaltung auf einfache Weise gesteuert werden. Dabei hat sich im Zusammenwirken mit den oben erwähnten Ausgestaltungen der Vorteil eines weitgehend linearen Zusammenhangs zwischen Steuerspannung oder Steuerstrom auf der einen Seite und der Frequenz des Ringoszillators auf der anderen Seite gezeigt.

Weitere bevorzugte Ausgestaltungen zeichnen sich durch wenigstens eine Spannungsquelle und/oder Stromquelle als Quelle elektrischer Energie aus.

Alternativ oder ergänzend ist bevorzugt, dass entweder eine einzige Stromquelle alle Verzögerungszellen mit elektrischer Energie versorgt, oder dass jeder Stromquelle eine eigene Stromquelle für die Versorgung mit elektrischer Energie besitzt.

Dabei hat sich gezeigt, dass eine Spannungsversorgung im direkten Vergleich mit einer Stromversorgung zu einer besseren Linearität zwischen Steuereingriff und Frequenzantwort führt.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: ein Ausführungsbeispiel einer erfindungsgemäßen Schaltung;
- Fig. 2: einen Ringoszillator mit vier Verzögerungszellen mit einer inneren Struktur nach der Fig. 1;
- Fig. 3: den Ringoszillator aus der Fig. 2 zusammen mit einer verallgemeinerten internen Struktur der Verzögerungszellen; und
- Fig. 4: ausschnittsweise Eingangssignale und ein resultierendes Ausgangssignal einer Verzögerungszelle.

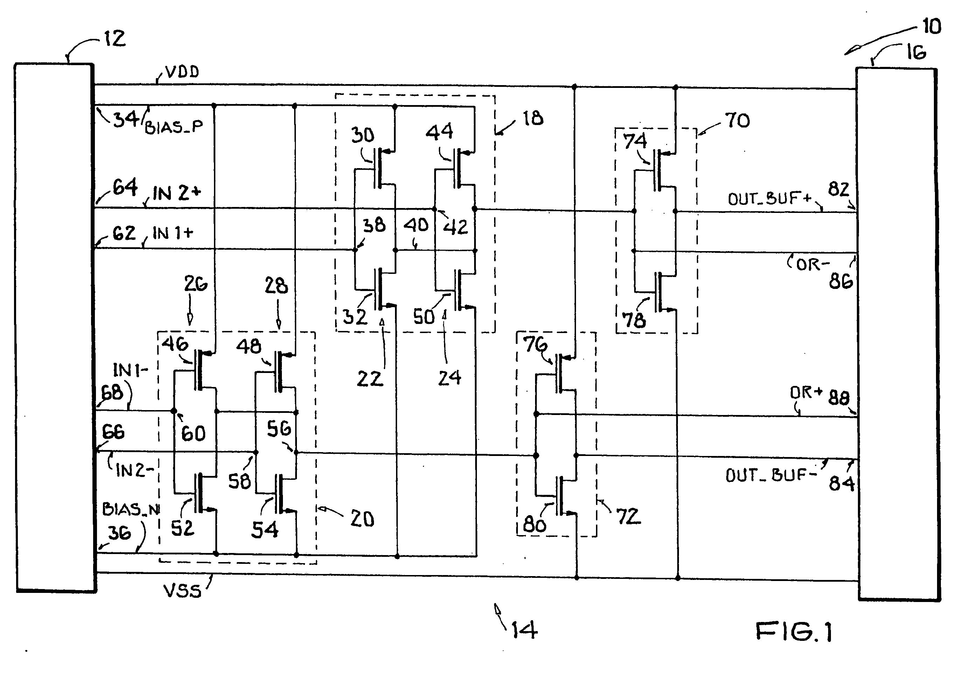

Im Einzelnen zeigt Fig. 1 eine Schaltung 10 mit einem Eingangsschaltkreis 12, einer Verzögerungszelle 14 und einem Ausgangsschaltkreis 16. Die Verzögerungszelle 14 weist zwei Paare 18, 20 von Invertern 22, 24 und 26, 28 auf. Ein erster Inverter 22 des ersten Paares 18 ist bevorzugt als CMOS-Inverter aus einem PMOS-Feldeffekttransistor 30 und einem NMOS-Feldeffektransistor 32 aufgebaut, deren Kanäle zwischen einem Anschluss 34 mit positivem elektrischen Potential BIAS_P und einem Anschluss 36 mit negativem elektrischen Potential BIAS_N liegen. Wenn der als Eingang des Inverters 22 dienende Gate-Anschluss 38 mit einem positiven Potential angesteuert wird, leitet der Kanal des NMOS-Transistors 32, und der Kanal des PMOS-Transistor 30 ist gesperrt. Als Folge stellt sich am Ausgang 40 des Inverters 22 das negative Potential des Anschlusses 36 ein. Umgekehrt stellt sich bei negativem Potential am Gate-Anschluss 38 und als Folge sperrendem NMOS-Transistor 32 und leitendem PMOS-Transistor 30 das positive Potential des Anschlusses 34 am Ausgang 40 ein. Am Ausgang 40 stellt sich damit jeweils das invertierte Gate-Potential oder Eingangssignal ein, wobei das Signal am Ausgang 40 dem Signal am Eingang 38 jeweils mit einer durch die Transistoreigenschaften verursachten Verzögerung folgt, die zum Beispiel vom Potentialunterschied zwischen den Anschlüssen 34 und 36 abhängig ist.

Die anderen Inverter 24, 26, 28 sind entsprechend aus PMOS-Transistoren 44, 46, 48 und NMOS-Transistoren 50, 52, 54 aufgebaut und arbeiten auf entsprechende Weise. Der Inverter 24 des ersten Paars 18 invertiert also das an seinem Eingang (Gate) 42 anliegende Eingangssignal. Da der Ausgang des Inverters 24 mit dem Ausgang des Inverters 22 elektrisch zu einem gemeinsamen Ausgang 40 verbunden ist, kann das Potential an diesem Ausgang 40 also über jeweils einen der beiden Eingänge 38, 42 der Inverter 22, 24 beeinflusst werden. Ein stabiles Potential stellt sich am Ausgang dann ein, wenn beide Inverter mit Signalen gleichen Vorzeichens angesteuert werden. Bei ungleichem Vorzeichen kann sich dagegen ein Stromfluss über je einen leitenden Transistor der beiden Inverter und den gemeinsamen Ausgang ergeben.

Ähnlich kann das Potential am Ausgang 56 des zweiten Paares 20 von Invertern 26, 28 über' jeweils einen der beiden Eingänge 58, 60 der Inverter 28, 26 beeinflusst werden. Dabei ist der Eingang 38 des Inverters 22 getrennt von den Eingängen 42, 58, 60 anderer Inverter 24, 26, 28 mit einem eigenen Eingang 62 der Verzögerungszelle 14 verbunden. Dies gilt analog für die Verbindungen von jeweils einem der Eingänge 42, 58, 60 der Inverter 24, 26, 28 mit jeweils einem eigenen Eingang 64, 66, 68 der Verzögerungszelle 14. Der Eingang 62 wird im folgenden auch als IN1+ Eingang bezeichnet. Analog werden die Eingänge 64, 66, 68 in dieser Reihenfolge auch als IN2+, IN2- und IN1- Eingänge bezeichnet.

Optional weist die Verzögerungszelle 10 für jeden Ausgang 40, 56 der Paare 18, 20 von Invertern 22, 24 und 26, 28 jeweils ein Verstärkerelement 70, 72 zur Auskopplung von Signalen an den Ausgängen 40, 56 auf. Durch die Verstärkerelemente 70, 72, die im Ausführungsbeispiel der Fig. 1 ebenfalls als CMOS-Inverter mit PMOS-Transistoren 74, 76 und NMOS-Transistoren 78, 80 realisiert sind, werden unerwünschte Rückwirkungen von Impedanzen im Ausgangsschaltkreis 16 auf die Signale an den Ausgängen 40, 56 der Verzögerungszelle 14 minimiert. Im Ausführungsbeispiel der Fig. 1 werden auszukoppelnde, von den Verstärkern 70 und 72 invertierte Signale OUT_BUF+, OUT_BUF- an Eingänge 82, 84 der Ausgangsschaltung 16 übergeben während die an Eingänge 86, 88 übergebenen, von den Verstärkern 70, 72 nicht invertierten Signale OR-, OR+ an weitere Verzögerungszellen in der Ausgangsschaltung 16 weitergeführt werden können.

Im Ausführungsbeispiel der Fig. 1 werden die Verstärkerelemente 70, 72 über Versorgungspotentiale VDD, VSS mit Energie versorgt. Aus diesen Versorgungspotentialen VDD, VSS werden innerhalb des Eingangsschaltkreises 12 auch die Potentiale an den Anschlüssen 34 und 38 des Eingangsschaltkreises gewonnen, mit denen die Verzögerungszeit der Inverter 22, 24, 26, 28 gesteuert werden kann.

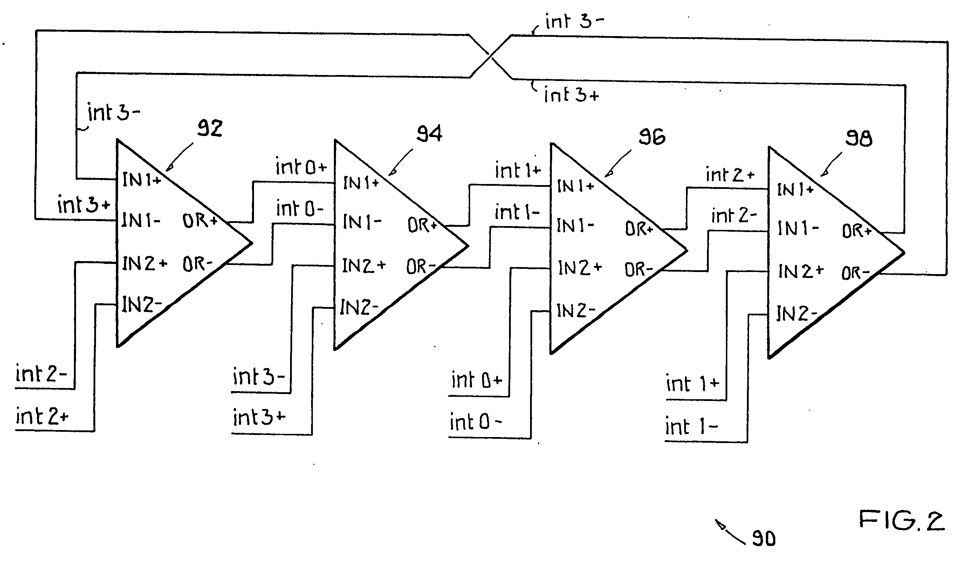

Fig. 2 zeigt einen Ringoszillator 90 mit vier Verzögerungszellen 92, 94, 96, 98, von denen jede einzelne die in Verbindung mit der Fig. 1 beschriebene Struktur mit Paaren von Invertern mit gemeinsamem Ausgang besitzt. Dabei ist in der Fig. 2 aus Gründen der Übersichtlichkeit auf die Darstellung der Energieversorgung und der Signalauskopplung verzichtet worden.

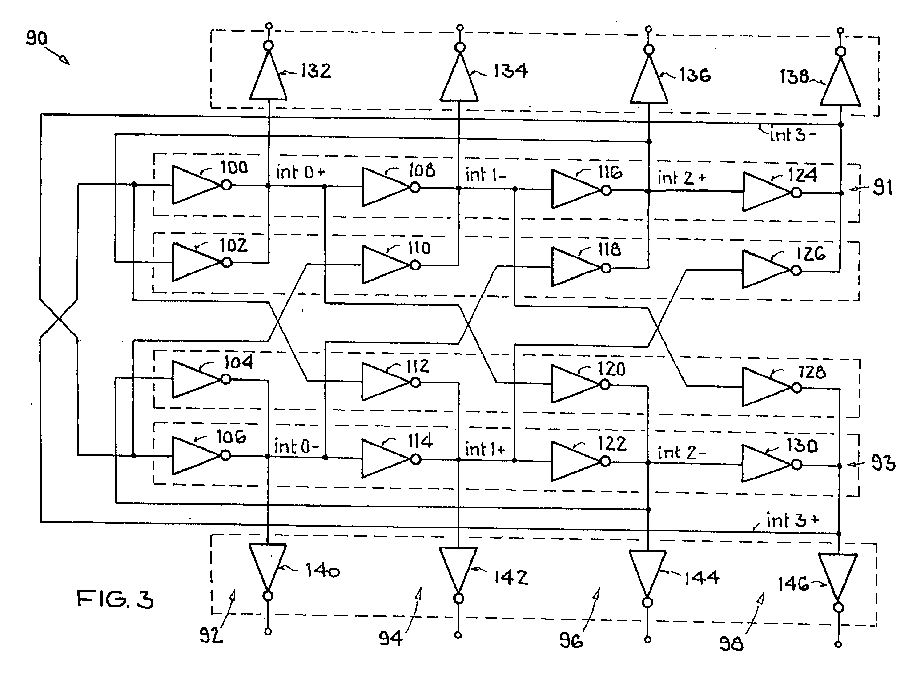

Die 2-te Verzögerungszelle 96 empfängt Signale int1+, int1- von der unmittelbar davor angeordneten ersten Verzögerungszelle 94 und Signale int0+ und int0- von dem Vorgänger der Verzögerungszelle 94, also von der 0-ten Verzögerungszelle 92. Analog empfängt die 3-te Verzögerungszelle 98 Signale int2+ und int2- von ihrem Vorgänger, der zweiten Verzögerungszelle 96 und Signale int1+ und int1- von ihrem Vor-Vorgänger, der 1-ten Verzögerungszelle 94. Die Ausgangssignale int3+ und int3- der dritten Verzögerungszelle 98 und die Ausgangssignale int2+ und int2- der zweiten Verzögerungszelle 96 werden jeweils über Kreuz zur 0-ten Verzögerungszelle 92 zurückgeführt. Die 1-te Verzögerungszelle 94 wird mit den Ausgangssignalen int0+ und int0- der 0-ten Verzögerungszelle 92 sowie mit den über Kreuz zurückgeführten Ausgangssignalen int3- und int3+ der dritten Verzögerungszelle 98 gespeist. Durch diese Art der Hintereinanderschaltung der Verzögerungszellen 92, 94, 96 und 98 entsteht der Ringoszillator 90, der zwei Ketten 91, 93 aufweist, in denen sich Signale mit entgegengesetzten Phasen synchron ausbreiten. Eine erste Kette 91 wird durch den Signalpfad der Signale int0+, int1-, int2+ und int3- repräsentiert. Analog ergibt sich eine zweite Kette 93 durch den Signalpfad der Signale int0-, int1+, int2- und int3+. Dies tritt im Zusammenhang mit der Fig. 3 deutlicher hervor.

Fig. 3 stellt den Ringoszillator 90 aus der Fig. 2 zusammen mit einer internen Struktur der vier Verzögerungszellen 92, 94, 96, 98 dar, um den Zusammenhang zwischen den Figuren 1 und 2 besser zu verdeutlichen. Dabei sind die CMOS-Inverter 22, 24, 26, 28, 70 und 72 einer einzelnen Verzögerungszelle 18 aus Fig. 1 in der Fig. 3 durch allgemeinere Darstellungen von Invertern ersetzt worden, wie sie bei einer Realisierung der Erfindung in einer allgemeineren Form ebenfalls verwendet werden können.

In der Fig. 3 geben die zusammengeschalteten beiden oberen Inverter 100, 102 der Zelle 92 das Signal int0+ aus, das dem Signal OR+ aus Fig. 1 entspricht. Nach Fig. 1 wird OR+ von dem unteren Inverterpaar 20 in Fig. 1 geliefert, deren Ausgänge zusammengeschaltet sind. Die oberen beiden Inverter 100, 102 der Zelle 92 entsprechen daher von den Signalen her den unteren beiden Invertern 26, 28 aus Fig. 1. Die zusammengeschalteten beiden unteren Inverter 104, 106 der Zelle 92 aus Fig. 2 geben ein Signal int0-, das dem Signal OR- aus Fig. 1 entspricht und dort von dem oberen Inverterpaar 22, 24 geliefert wird, deren Ausgänge zusammengeschaltet sind. Die unteren Inverter 104, 106 der Verzögerungszelle 92 entsprechen also von den Signalen her den oberen beiden Invertern 22 und 24 aus Fig. 1.

Die zusammengeschalteten beiden oberen Inverter 108, 110 der Verzögerungszelle 94 geben int1- aus. Nach Fig. 2 wird Int1- vom Ausgang OR- abgenommen. Nach Fig. 2 wird OR- von dem oberen Inverterpaar 18 geliefert, deren Ausgänge zusammengeschaltet sind. Die oberen beiden Inverter 108, 110 der Verzögerungszelle 94 entsprechen also den oberen beiden Invertern 22, 24 aus Bild 1. Die zusammengeschalteten beiden unteren Inverter 112, 114 der Verzögerungszelle 94 aus Fig. 3 geben int0+ aus. Nach Fig. 2 wird Int0+ vom Ausgang OR+ abgenommen. Nach Fig. 1 wird OR+ von dem unteren Inverterpaar 20 geliefert, deren Ausgänge zusammengeschaltet sind. Die unteren Inverter der Verzögerungszelle 94 entsprechen also den unteren beiden Invertern 26, 28 aus Fig. 1.

Die zusammengeschalteten beiden oberen Inverter 116, 118 der Verzögerungszelle 96 geben int2+ aus. Nach Fig. 2 wird Int2+ vom Ausgang OR+, also von dem unteren Inverterpaar 20 aus Fig. 1 geliefert. Die oberen beiden Inverter 116, 118 der Verzögerungszelle 96 entsprechen also den unteren beiden Invertern 26, 28 aus Fig. 1. Die zusammengeschalteten beiden unteren Inverter 120, 122 der Verzögerungszelle 96 aus Fig. 3 geben int2- aus. Nach Fig. 2 wird Int2- vom Ausgang OR- abgenommen. Nach Fig. 1 wird OR- von dem oberen Inverterpaar 18 geliefert. Die unteren Inverter 120, 122 der Verzögerungszelle 96 entsprechen also den oberen beiden Invertern 22, 24 aus Fig. 1.

Die zusammengeschalteten beiden oberen Inverter 124, 126 der Verzögerungszelle 98 aus Fig. 3 geben int3- aus. Nach Fig. 2 wird Int3- vom Ausgang OR- abgenommen. Nach Fig. 1 wird OR- von dem oberen Inverterpaar 18 geliefert. Die oberen beiden Inverter 124, 126 der Verzögerungszelle 98 entsprechen also den oberen beiden Invertern 22, 24 aus Fig. 1. Die zusammengeschalteten beiden unteren Inverter 128, 130 der Verzögerungszelle 98 aus Fig. 3 geben int3+ aus. Nach Fig. 2 wird Int3+ vom Ausgang OR+ abgenommen. Nach Fig. 1 wird OR+ von dem unteren Inverterpaar 20 geliefert. Die unteren beiden Inverter 128, 130 der Verzögerungszelle 98 aus Fig. 3 entsprechen also den unteren beiden Invertern 26, 28 aus der Fig. 1. Die Inverter 132, 134, 136, 138, 140, 142, 144, 146 dienen der Auskopplung von Signalen mit verschiedenen Phasenlagen aus dem Ring 90 und entsprechen damit den Verstärkerelementen 70, 72 aus der Fig. 1.

Wie bereits weiter oben im Zusammenhang mit der Fig. 2 erwähnt wurde, ergeben sich durch diese Art der Hintereinanderschaltung der Verzögerungszellen 92, 94, 96 und 98 zwei Ketten, in denen sich Signale mit entgegengesetzten Phasen synchron ausbreiten. Die erste Kette wird durch den Signalpfad der Signale int0+, int1-, int2+ und int3- und damit gewissermaßen durch die erste Zeile der quer liegenden Inverter, also durch die Inverter 100, 108, 116 und 124 repräsentiert. Analog ergibt sich die zweite Kette durch den Signalpfad der Signale int0-, int1+, int2- und int3+ und damit durch die vierte Zeile der quer liegenden Inverter, also durch die Inverter 106, 114, 122 und 130. Die erste und die zweite Kette laufen synchron, aber mit entgegengesetzten Phasen, so dass zum Beispiel der Verstärker 132 die entgegengesetzte Phase auskoppelt wie der Verstärker 140, der Verstärker 134 die entgegengesetzte Phase auskoppelt wie der Verstärker 142, der Verstärker 136 die entgegengesetzte Phase auskoppelt wie der Verstärker 144 und der Verstärker 138 die entgegengesetzte Phase auskoppelt wie der Verstärker 146. Die Verkopplung der beiden Ketten, die dafür sorgt, dass beide Ketten synchron laufen, wird durch die weiteren Inverter 102, 104, 110, 112, 118, 120, 126 und 128 realisiert, deren Eingang jeweils an der einen Kette und deren Ausgang jeweils an der anderen Kette angeschlossen ist.

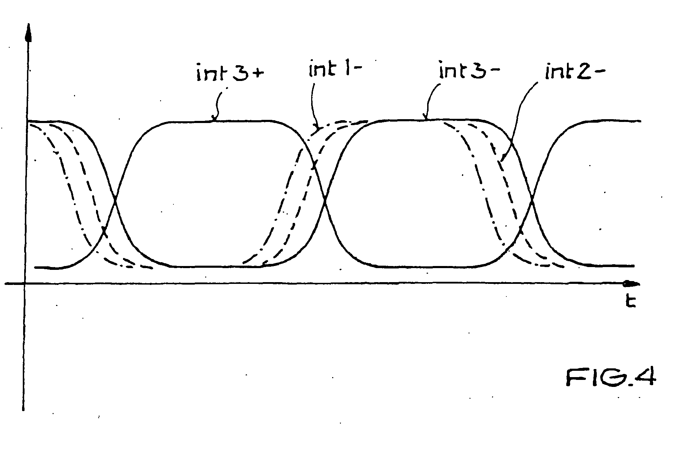

Aus der Schaltungstopologie nach Fig. 2 und/oder Fig. 3 ergibt sich, dass sich Eingangssignale zweier Inverter, deren Ausgänge jeweils zusammengeschaltet sind, nur geringfügig in ihrer Phase unterscheiden, wie es die Fig. 4 qualitativ zeigt.

Fig. 4 zeigt ausschnittsweise das Ausgangssignal int3+ der 3-ten Verzögerungszelle 98 aus Fig. 2 oder 3. Ihre Eingangssignale sind die Ausgangssignale int1- der 1-ten Verzögerungszelle 94 und int2- der 2-ten Verzögerungszelle 96, deren Flanken sich weit überlappen. Daher arbeiten die beiden Inverter 128, 130 der Verzögerungszelle 98, die int3+ ausgeben, nicht gegeneinander, sondern leicht zeitversetzt miteinander. Außerdem ergibt sich so ein Geschwindigkeitsvorteil, weil jede Verzögerungszelle mit Zählindex n nicht nur auf das von der unmittelbar vorhergehenden Verzögerungszelle mit Zählindex n-1 modulo N ausgegebene Signal reagiert, sondern bereits durch das Signal der vor-vorhergehenden Verzögerungszelle mit Zählindex (n-2) modulo N reagiert. Dadurch wird der Abstand benachbarter Phasen stark reduziert. Bei normalen, nicht symmetrischen Ringoszillatoren tritt die gleich Phase, also zum Beispiel 1 oder 0, nach zwei Invertern wieder auf, so dass der zeitliche Abstand der Summe der Signallaufzeiten durch beide Inverter entspricht. In der Fig. 4, die auf einer Realisierung mit k = 1 beruht, entspricht der Abstand benachbarter Phasen dagegen nur ca. 2/3 der Signallaufzeit eines Inverters, so dass die Schaltung dreimal so schnell ist wie der normale Ringoszillator. Der Geschwindigkeitsvorteil kann noch vergrößert werden, indem Schaltungsvarianten mit k > 1 realisiert werden. Darüber hinaus zeigt Fig. 4 einen Abschnitt des Signals int3-, das eine zum Signal int3+ entgegengesetzte Phasenlage besitzt. Die Signale sind in der Fig. 4 jeweils in willkürlichen Einheiten über der Zeit aufgetragen.

Insgesamt erlaubt die Erfindung und ihre Ausgestaltungen eine Realisierung von Ringoszillatoren, die eine gerade Anzahl von Taktsignalen gleicher Frequenz und mit unterschiedlichen Phasen bereitstellen und die einen geringen, von der Zahl der Phasen unabhängigen Strombedarf aufweisen, mit variablen, sehr kurzen Verzögerungszeiten oder Phasendifferenzen zwischen den Phasen und abstimmbarer Frequenz. Dabei wird die Frequenz bevorzugt über die Versorgungsspannung der Inverter eingestellt, weil der Zusammenhang zwischen Spannung und Frequenz in etwa linear ist, während bei einer Frequenzsteuerung über Steuerströme der Strom bei sehr hohen Frequenzen überproportional ansteigt. Es versteht sich, dass die Steuerung sowohl an der positiven an der negativen oder an beiden Versorgungen der Inverter im Ring stattfinden kann. Außerdem kann die Steuerung mit einer Spannungs- oder Stromquelle für alle Verzögerungszellen erfolgen. Alternativ kann sie mit separaten Stromquellen innerhalb jeder Zelle (Strombank), ähnlich wie in US 5 300 898, erfolgen. Weiter alternativ kann die Steuerung der Frequenz auch über variable Kapazitäten erfolgen, die je nach Ausgangssignal eines Inverters umgeladen werden. Es versteht sich ferner, dass anstelle eines geschlossenen Rings ein offener Ring, also eine Kette von Verzögerungszellen nach Fig. 1 genutzt werden kann, um verschieden verzögerte Versionen (Phasen) eines Eingangssignals zu erzeugen.

## Patentansprüche

1. Schaltung (10) mit wenigstens einer Verzögerungszelle (14; 92, 94, 96, 98), die eine Eingangssignaländerung verzögert in ein Ausgangssignal abbildet und die wenigstens zwei Paare (18, 20) von Invertern (22, 24, 26, 28; 100, 102, .... , 130) aufweist, wobei jeweils Ausgänge von Invertern (22, 24, 26, 28; 100, 102, .... , 130) eines Paares von Invertern (22, 24, 26, 28; 100, 102, .... , 130) miteinander verbunden sind, so dass die verbundenen Ausgänge eines ersten Paares von Invertern (22, 24, 26, 28; 100, 102, ...., 130) einen ersten Ausgang und die verbundenen Ausgänge eines zweiten Paares einen zweiten Ausgang der Verzögerungszelle (14; 92, 94, 96, 98) bilden, **dadurch gekennzeichnet, dass** jeweils ein Eingang (38, 42, 58, 60) jedes Inverters (22, 24, 26, 28; 100, 102, .... , 130) getrennt von Eingängen anderer Inverter (22, 24, 26, 28; 100, 102, .... , 130) mit einem eigenen Eingang (62, 64, 66, 68) der Verzögerungszelle (14; 92, 94, 96, 98) verbunden ist.

2. Schaltung (10) nach Anspruch 1, **dadurch gekennzeichnet, dass** die Inverter (22, 24, 26, 28; 100, 102, .... , 130) als CMOS-Inverter realisiert sind.

3. Schaltung (10) nach Anspruch 1 oder 2, **dadurch gekennzeichnet, dass** wenigstens ein Ausgang der Verzögerungszelle (14; 92, 94, 96, 98) an ein Verstärkerelement (70, 72) angeschlossen ist.

4. Schaltung (10) nach Anspruch 3, **gekennzeichnet durch** ein einen weiteren Inverter als Verstärkerelement (70, 72).

5. Schaltung (10) nach wenigstens einem der vorhergehenden Ansprüche, **dadurch gekennzeichnet, dass** die Schaltung (10) eine durch zwei teilbare Zahl N von Verzögerungszellen (92, 94, 96, 98) aufweist, die größer oder gleich vier ist, wobei Eingänge wenigstens einer n-ten Verzögerungszelle mit Ausgängen von wenigstens einer n - 1 modulo N -ten und einer n - 2 modulo N -ten Verzögerungszelle verbunden sind.

6. Schaltung (10) nach wenigstens einem der vorhergehenden Ansprüche, **dadurch gekennzeichnet, dass** die wenigstens vier Verzögerungszellen (92, 94, 96, 98) so miteinander verbunden sind, dass sich ein erster Signalpfad über eine erste Kette (91) von Invertern (100, 108, 116, 124) und ein zweiter Signalpfad über eine zweite Kette (93) von Invertern (106, 114, 122, 130) ergeben, wobei Signale in beiden Signalpfaden mit entgegengesetzter Phase synchron fortschreiten und wobei Eingänge von Invertern der ersten Kette (91), die zu einer n-ten Verzögerungszelle gehören, an Ausgänge von Invertern der ersten Kette (91), die zu einer (n - 2k +/- 1) modulo N - ten Verzögerungszelle (92, 94, 96, 98) gehören und an Ausgänge von Invertern der zweiten Kette (93), die, die zu einer (n - 2k -ten) modulo N -Verzögerungszelle (92, 94, 96, 98) gehören, angeschlossen sind, wobei k eine natürliche Zahl größer oder gleich 1 ist.

7. Schaltung (10) nach Anspruch 5 oder 6, **dadurch gekennzeichnet, dass** wenigstens vier Verzögerungszellen (92, 94, 96, 98) der Schaltung (10) zu einem Ringoszillator (90) verbunden sind.

8. Schaltung (10) nach wenigstens einem der vorhergehenden Ansprüche, **gekennzeichnet durch** wenigstens eine Quelle elektrischer Energie, die an Versorgungsanschlüsse wenigstens eines der Inverter (22, 24, 26, 28) angeschlossen ist.

9. Schaltung (10) nach Anspruch 8, **gekennzeichnet durch** wenigstens eine Spannungsquelle und/oder Stromquelle als Quelle elektrischer Energie.

10. Schaltung (10) nach Anspruch 9 und wenigstens einer Stromquelle als Quelle elektrischer Energie, **dadurch gekennzeichnet, dass** entweder eine einzige Stromquelle alle Verzögerungszellen mit elektrischer Energie versorgt, oder dass jeder Stromquelle eine eigene Stromquelle für die Versorgung mit elektrischer Energie besitzt.
